# EUROPEAN PATENT APPLICATION

(11) **EP 4 319 532 A1**
(43) Date of publication of application: **07.02.2024**
(21) Application number: 23171244.9
(22) Date of filing: 03.05.2023
(51) Int. Cl.: H10B 41/27, H10B 43/27, H10B 80/00, H01L 23/00

(54) **SEMICONDUCTOR DEVICES AND DATA STORAGE SYSTEMS INCLUDING THE SAME**

(30) Priority: 02.08.2022 KR 20220095917
(71) Applicant: Samsung Electronics Co., Ltd., Suwon-si, Gyeonggi-do 16677 (KR)
(72) Inventor: KIM, Jiyoung, 16677 Suwon-si, Gyeonggi-do (KR); KIM, Dohyung, 16677 Suwon-si, Gyeonggi-do (KR); KIM, Jiwon, 16677 Suwon-si, Gyeonggi-do (KR); SUNG, Sukkang, 16677 Suwon-si, Gyeonggi-do (KR)
(74) Representative: Kuhnen & Wacker Patent- und Rechtsanwaltsbüro PartG mbB

(57) **Abstract**

A semiconductor device (100) may include a first semiconductor structure (S1) including a lower substrate (201); and a second semiconductor structure (S2) on and bonded to the first semiconductor structure (S1) through a bonding structure (195, 196, 198, 295, 298). The second semiconductor structure (S2) may include: a pattern structure (101); an upper insulating layer (199) on the pattern structure (101); a stack structure (GS) including gate electrode layers (130) and interlayer insulating layers (120) alternately stacked between the first semiconductor structure (S1) and the pattern structure (101); channel structures (CH) that extend through the stack structure (GS); separation structures (MS) that extend through the stack structure (GS) and separate the stack structure (GS). Each of the separation structures (MS) may include a first portion (MS_P1) that extends through the stack structure (GS) and a second portion (MS_P2) that extends from the first portion (MS_P1) and extends through the pattern structure (101), and the second semiconductor structure (S2) further may include a spacer layer (105) that separates the second portion (MS_P2) of each separation structure from the pattern structure (101).

## Description

### BACKGROUND

The present inventive concepts relate to semiconductor devices and to data storage systems including the semiconductor devices.

Data storage systems requiring data storage require semiconductor devices capable of storing high-capacity data. Accordingly, methods for increasing data storage capacity of semiconductor devices have been studied. For example, one method for increasing data storage capacity of semiconductor devices has been proposed in which a semiconductor device includes memory cells arranged three-dimensionally, instead of memory cells arranged two-dimensionally.

### SUMMARY

Some aspects of the present inventive concepts provide semiconductor devices having improved productivity.

Some aspects of the present inventive concepts provide data storage systems including semiconductor devices having improved productivity.

According to some aspects of the present inventive concepts, a semiconductor device may include a first semiconductor structure including a lower substrate; and a second semiconductor structure on and bonded to the first semiconductor structure through a bonding structure. The second semiconductor structure may include: a pattern structure; an upper insulating layer on the pattern structure; a stack structure including gate electrode layers and interlayer insulating layers alternately stacked between the first semiconductor structure and the pattern structure in a vertical direction that is perpendicular to a lower surface of the pattern structure; channel structures that extend through the stack structure and respectively include a channel layer; and separation structures that extend through the stack structure and separate the stack structure. Each of the separation structures includes a first portion that extends through the stack structure and a second portion that extends vertically from the first portion and extends through the pattern structure. The second semiconductor structure may further include a spacer layer that separates the second portion of each separation structure from the pattern structure.

According to some aspects of the present inventive concepts, a semiconductor device includes: a lower substrate; circuit elements on the lower substrate; a lower wiring structure electrically connected to the circuit elements; a lower bonding structure connected to the lower wiring structure; an upper bonding structure bonded to the lower bonding structure; an upper wiring structure connected to the upper bonding structure; a pattern structure on the upper wiring structure; gate electrode layers stacked on each other in a vertical direction, perpendicular to a lower surface of the pattern structure; channel structures that extend through the gate electrode layers and respectively include a channel layer; and separation structures that extend in a first horizontal direction through the gate electrode layers and separate the gate electrode layers, wherein each of the separation structures includes a first portion that extends through the gate electrode layers, a second portion that is on the first portion and that extends through the pattern structure on the first portion, and a bent portion defined by the first portion and the second portion.

According to some aspects of the present inventive concepts, a data storage system includes: a semiconductor storage device including a first semiconductor structure including a lower substrate, circuit elements on the lower substrate a second semiconductor structure on and bonded to the first semiconductor structure, and an input/output (I/O) pad electrically connected to the circuit elements; and a controller electrically connected to the semiconductor storage device through the I/O pad and controlling the semiconductor storage device. The second semiconductor structure may include: a pattern structure; an upper insulating layer on the pattern structure; a stack structure including gate electrode layers and interlayer insulating layers alternately stacked between the first semiconductor structure and the pattern structure in a vertical direction that is perpendicular to a lower surface of the pattern structure; channel structures that extend through the stack structure and respectively include a channel layer; and separation structures that extend through the stack structure and separate the stack structure. Each of the separation structures may include a first portion that extends through the stack structure and a second portion that extends vertically from the first portion and extends through the pattern structure, and the second semiconductor structure may further include a spacer layer that separates the second portion of each separation structure from the pattern structure.

According to some aspects of the present inventive concepts, a method of manufacturing a semiconductor device includes: forming a first semiconductor structure including a lower substrate, circuit elements on the lower substrate, a lower wiring structure electrically connected to the circuit elements, and a lower bonding structure connected to the lower wiring structure; forming a preliminary stack structure including sacrificial insulating layers and interlayer insulating layers alternately stacked on a base substrate in a vertical direction that is to an upper surface of the base substrate; forming channel structures that extend through the preliminary stack structure and include channel layers; forming a preliminary separation structure that extends through the preliminary stack structure and extend in a first horizontal direction that is perpendicular to the vertical direction; forming an upper wiring structure and an upper bonding structure on the preliminary separation structure to form a second preliminary semiconductor structure; bonding the lower bonding structure of the first semiconductor structure to the upper bonding structure of the second preliminary semiconductor structure; removing the base substrate and forming a pattern structure connected to the channel structures; forming openings exposing the preliminary separation structure through the pattern structure; removing the preliminary separation structure through the openings; selectively removing the sacrificial insulating layers to form tunnel portions; and forming gate electrode layers in the tunnel portions.

### BRIEF DESCRIPTION OF THE DRAWINGS

The above and other aspects, features, and advantages of the present inventive concept will be more clearly understood from the following detailed description, taken in conjunction with the accompanying drawings, in which:
FIG. 1 is a schematic plan view of a semiconductor device according to some embodiments;
FIGS. 2A and 2B are schematic cross-sectional views of a semiconductor device according to some embodiments;
FIGS. 3A and 3B are partially enlarged views of a semiconductor device according to some embodiments;
FIGS. 4A and 4B are partially enlarged views of a semiconductor device according to some embodiments;
FIG. 5 is a partially enlarged view of a semiconductor device according to some embodiments;
FIGS. 6A and 6B are schematic plan views of semiconductor devices according to some embodiments;
FIG. 7 is a schematic cross-sectional view of a semiconductor device according to some embodiments;
FIG. 8 is a partially enlarged view of a semiconductor device according to some embodiments;
FIGS. 9, 10A, 10B, 11, 12A, 12B, 13, 14 and 15 are schematic cross-sectional views illustrating a method of manufacturing a semiconductor device according to some embodiments;
FIG. 16 is a view schematically illustrating a data storage system including a semiconductor device according to some embodiments;
FIG. 17 is a perspective view schematically illustrating a data storage system including a semiconductor device according to some embodiments; and
FIG. 18 is a cross-sectional view schematically illustrating a semiconductor package according to some embodiments.

### DETAILED DESCRIPTION

Hereinafter, some examples of embodiments of the present inventive concepts will be described with reference to the accompanying drawings.

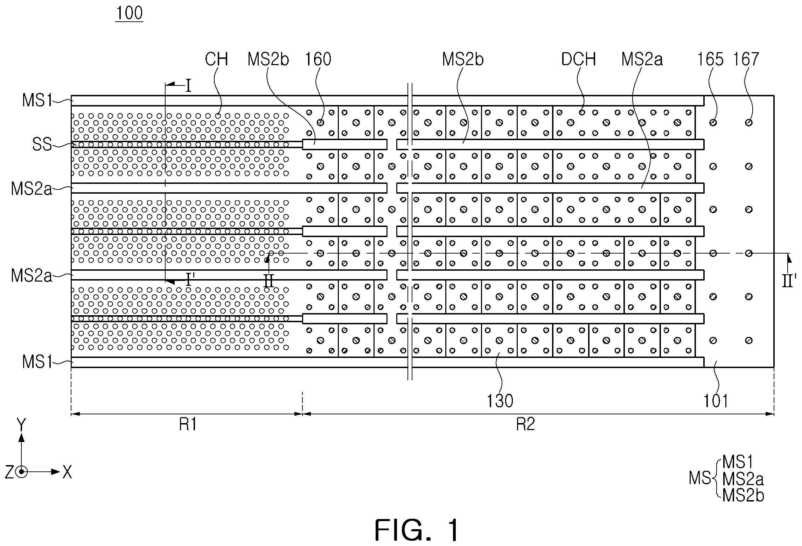

FIG. 1 is a schematic plan view of a semiconductor device according to some embodiments.

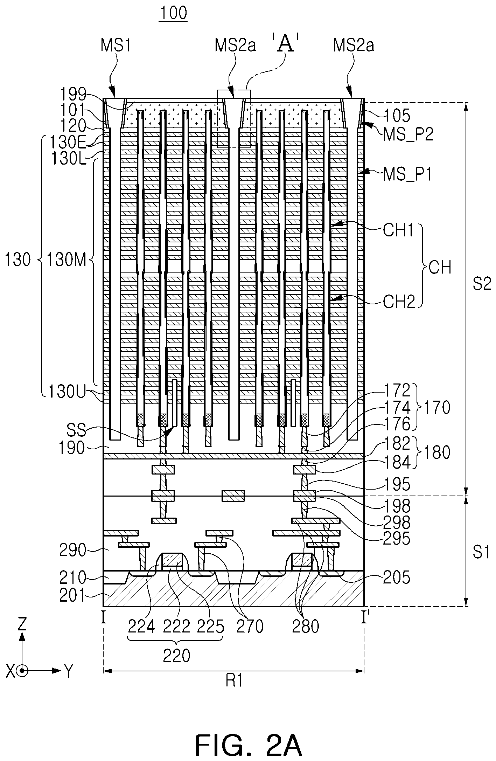

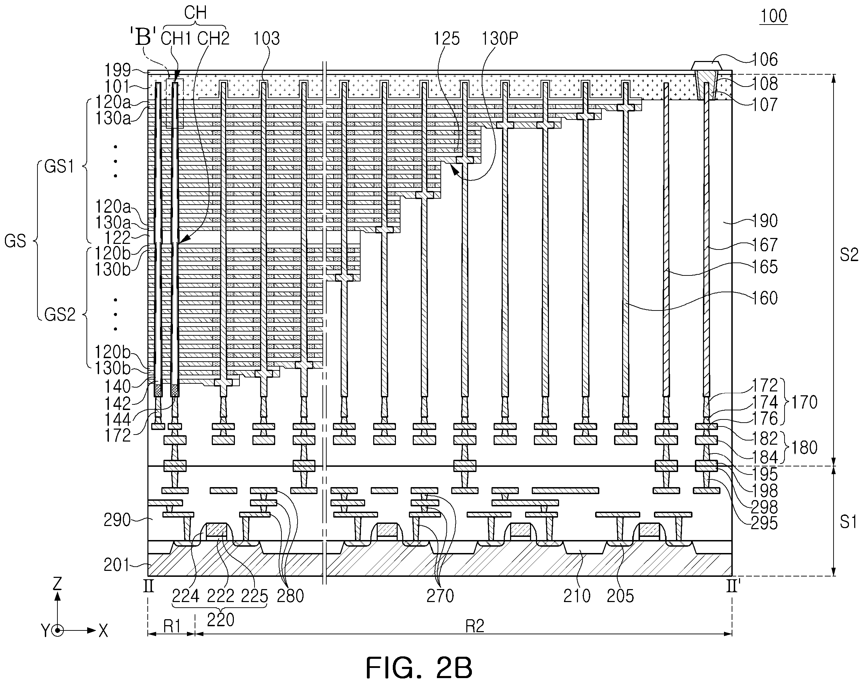

FIGS. 2A and 2B are schematic cross-sectional views of a semiconductor device according to some embodiments. FIG. 2A is a cross-sectional view taken along line I-I' of FIG. 1, and FIG. 2B is a cross-sectional view taken along line II-II' of FIG. 1.

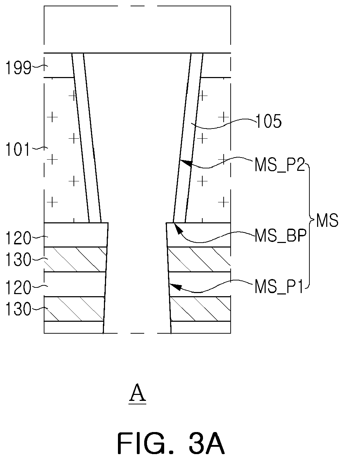

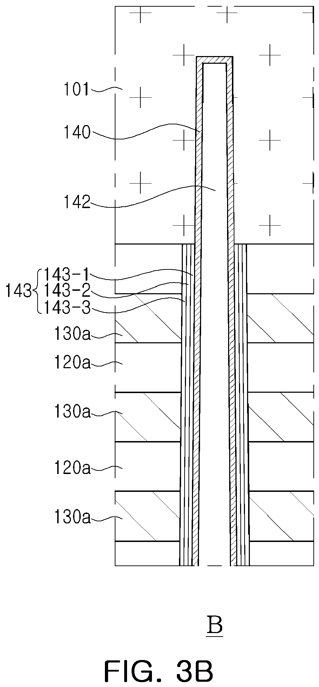

FIGS. 3A and 3B are partially enlarged views of a semiconductor device according to some embodiments. FIG. 3A is an enlarged view of region 'A' of FIG. 2A, and FIG. 3B is an enlarged view of region 'B' of FIG. 2B.

Referring to FIGS. 1 to 3B, the semiconductor device 100 includes first and second semiconductor structures S1 and S2 stacked vertically. For example, the first semiconductor structure S1 may include a peripheral circuit region of the semiconductor device 100, and the second semiconductor structure S2 may include a memory cell region of the semiconductor device 100. In FIG. 1, a plane is illustrated in a direction in which the second semiconductor structure S2 is viewed from an interface between the first and second semiconductor structures S1 and S2.

The first semiconductor structure S1 may include a lower substrate 201, source/drain regions 205 and device separation layers 210 in the lower substrate 201, circuit elements 220 on the lower substrate 201, circuit contact plugs 270, circuit wiring lines 280, a peripheral region insulating layer 290, first bonding vias 295, and first bonding metal layers 298.

The lower substrate 201 may have an upper surface that extends in an X-direction and a Y-direction, that is, a first horizontal direction X and a second horizontal direction Y. The device separation layers 210 may be formed on the lower substrate 201 to define active regions. The source/drain regions 205 including impurities may be in a portion of an active region defined by the device separation layers 210. The lower substrate 201 may include a semiconductor material, for example, a group IV semiconductor, a group III-V compound semiconductor, or a group II-VI compound semiconductor. For example, the lower substrate 201 may be provided as a single crystal bulk wafer.

The circuit elements 220 may include planar transistors. Each of the circuit elements 220 may include a circuit gate dielectric layer 222, a spacer layer 224, and a circuit gate electrode layer 225. The source/drain regions 205 may be in the lower substrate 201 at first and second sides of the circuit gate electrode layer 225, for example in the Y-direction.

A peripheral region insulating layer 290 may be on the lower substrate 201 and may cover the circuit elements 220. The circuit contact plugs 270 and the circuit wiring lines 280 may form the lower wiring structures 270 and 280 of the first semiconductor structure S1. The circuit contact plugs 270 may have a cylindrical shape and may pass through or extend within the peripheral region insulating layer 290, and the circuit contact plugs 270 may be connected to the source/drain regions 205. An electrical signal may be applied to the circuit elements 220 by or through the circuit contact plugs 270. In a region not illustrated, the circuit contact plugs 270 may also be connected to the circuit gate electrode layer 225. The circuit wiring lines 280 may be connected to the circuit contact plugs 270, may have a line shape, and may be arranged as a plurality of layers. According to some embodiments, the number of layers of the circuit contact plugs 270 and the circuit wiring lines 280 may be variously changed.

The first bonding vias 295 and the first bonding metal layers 298 may constitute the lower bonding structures 295 and 298 and may be on a portion of the uppermost circuit wiring lines 280. The lower bonding structures 295 and 298 may be connected to the lower wiring structures 270 and 280. The first bonding vias 295 may have a cylindrical shape, and the first bonding metal layers 298 may have a circular pad shape or a relatively short line shape in plan view. Upper surfaces of the first bonding metal layers 298 may be exposed as an upper surface of the first semiconductor structure S1. The first bonding vias 295 and the first bonding metal layers 298 may function as bonding structures or bonding layers of the first semiconductor structure S1 and the second semiconductor structure S2. In addition, the first bonding vias 295 and the first bonding metal layers 298 may provide an electrical connection path from the first semiconductor structure S1 (and devices thereof) to the second semiconductor structure S2. According to some embodiments, some of the first bonding metal layers 298 may be provided only for bonding, without being connected to the lower circuit wiring lines 280, as illustrated in FIG. 2A. The first bonding vias 295 and the first bonding metal layers 298 may include a conductive material, for example, copper (Cu).

According to some embodiments, the peripheral region insulating layer 290 may include a bonding insulating layer having a predetermined thickness from the upper surface. The bonding insulating layer may be a layer for dielectric-dielectric bonding with the bonding insulating layer of the second semiconductor structure S2. The bonding insulating layer may also function as a diffusion barrier layer of the first bonding metal layers 298, and may include, for example, at least one of SiO, SiN, SiCN, SiOC, SiON, and SiOCN.

The second semiconductor structure S2 may include a pattern structure 101 having a first region R1 and a second region R2, a stack structure GS including gate electrode layers 130 that are stacked on a lower surface of the pattern structure 101 and alternately stacked with interlayer insulating layers 120, channel structures CH which may extend through or pass through the stack structure GS, and separation structures MS extending in length in one direction through the stack structure GS. The second semiconductor structure S2 may further include upper separation structures SS that pass or extend through a portion of the gate electrode layers 130, a cell region insulating layer 190 that covers the gate electrode layers 130, and an upper insulating layer 199 on the pattern structure 101. The second semiconductor structure S2 may further include gate contacts 160 below the gate electrode layers 130 and the channel structures CH, a substrate contact 165, an input/output (I/O) contact 167, cell contact plugs 170, and cell wiring lines 180, as upper wiring structures 160, 165, 167, 170, and 180. The second semiconductor structure S2 may further include second bonding vias 195 and second bonding metal layers 198, as upper bonding structures 195 and 198.

The pattern structure 101 may have an upper surface that extends in the X-direction and the Y-direction. The pattern structure 101 may include a semiconductor material, for example, a group IV semiconductor, a group III-V compound semiconductor, or a group II-VI compound semiconductor. For example, the group IV semiconductor may include silicon, germanium, or silicon-germanium. The pattern structure 101 may further include impurities. The pattern structure 101 may be provided as a polycrystalline semiconductor layer, such as a polycrystalline silicon layer or an epitaxial layer.

The first region R1 of the pattern structure 101 may be a region in which the gate electrode layers 130 are vertically stacked and the channel structures CH are provided, and may be a region in which memory cells are provided. The second region R2 of the pattern structure 101 may be a region in which the gate electrode layers 130 extend to have different lengths, and may correspond to a region for electrically connecting the memory cells to the first semiconductor structure S1. The second region R2 may be located at at least one end of the first region R1 in at least one horizontal direction, for example, the X-direction.

The gate electrode layers 130 may be stacked to be vertically spaced apart from each other on the lower surface of the pattern structure 101 to form a stack structure GS together with the interlayer insulating layers 120. Referring to FIG. 2B, the stack structure GS may include a first stack structure GS1 and a second stack structure GS2, which may be vertically stacked such that the first stack structure GS1 is below the first stack structure GS1. However, according to various embodiments, the number of stages of the stack structure GS is not particularly limited to the arrangement of the figures, may be variously changed, and in some embodiments a single stack structure GS may be formed. The gate electrode layers 130 may include first gate electrode layers 130a of the first stack structure GS1 and second gate electrode layers 130b of the second stack structure GS2.

Referring to FIG. 2A, the gate electrode layers 130 may include erase gate electrode layers 130E constituting an erase transistor used in an erase operation, at least one lower gate electrode layer 130L constituting a gate of a ground selection transistor, memory gate electrode layers 130M forming a plurality of memory cells, and an upper gate electrode layer 130U forming gates of string select transistors. Here, the lower gate electrode layer 130L and the upper gate electrode layers 130U may be referred to as "lower" and "upper" based on a direction during a manufacturing process, which may differ from an arrangement in a final assembly. The number of the memory gate electrode layers constituting the memory cells may be determined according to a capacity of the semiconductor device 100. According to some embodiments, each of the upper and lower gate electrode layers 130U and 130L may be one to four (1 to 4) or more, and may have a structure that is the same as or different from the memory gate electrode layers 130M. The erase gate electrode layers 130E may be below the upper gate electrode layer 130U and/or on the lower gate electrode layer 130L and may be used for an erase operation using a gate induced drain leakage (GIDL) phenomenon. However, according to some embodiments, the erase gate electrode layers 130E may be omitted.

At least some of the gate electrode layers 130, for example, the memory gate electrode layers adjacent to the upper or lower gate electrode layers 130U and 130L may be dummy gate electrode layers.

The gate electrode layers 130 may be stacked and may be vertically spaced apart from each other on the lower surface of the pattern structure 101, and may extend from the first region R1 to the second region R2 at different lengths to form a step structure having steps of various lengths. The gate electrode layers 130 may have a step structure in the X-direction and may also have a step structure also in the Y-direction. According to some embodiments, at least some of the gate electrode layers 130a and 130b, that is, a certain number of gate electrodes 130a and 130b, for example, two to six gate electrodes 130a and 130b, may form a single gate group, and a step structure in the X-direction may be formed using the gate groups.

Due to the step structure, an upper gate electrode layer 130 may extend further than the lower gate electrode layer 130, resulting in regions in which the lower surfaces of the gate electrode layers 130 are exposed downwardly from the interlayer insulating layers 120, respectively, and the regions may be referred to as gate pad regions 130P. In each gate electrode layer 130, the gate pad region 130P may be a region including an end portion in the X-direction. The gate pad region 130P may correspond to a portion of the gate electrode layer 130 located at the lowermost position in each region, among the gate electrode layers 130 constituting the stack structure GS in the second region R2 of the pattern structure 101. The gate electrode layers 130 may be connected to the gate contacts 160 in the gate pad regions 130P. In each of the gate electrode layers 130, a region other than the gate pad region 130P may be referred to as a stack region, and the stack region may be a portion in which a lower surface is not exposed from the interlayer insulating layers 120. The gate electrode layers 130 may have an increased thickness in the gate pad regions 130P.

The gate electrode layers 130 may be at least partially separated at a predetermined unit or distance by the separation structures MS in the Y-direction. The gate electrode layers 130 may form a single memory block between a pair of first separation structures MS1 that are adjacent to each other, but the scope of the memory block is not limited thereto.

The gate electrode layers 130 may include a metal material, for example, tungsten (W). According to some embodiments, the gate electrode layers 130 may include polycrystalline silicon or a metal silicide material.

The interlayer insulating layers 120 may be between the gate electrode layers 130. Like the gate electrode layers 130, the interlayer insulating layers 120 may be spaced apart from each other in a direction that is perpendicular to the lower surface of the pattern structure 101, and the interlayer insulating layers 120 may extend in the X-direction. Referring to FIG. 2B, the interlayer insulating layers 120 may include first interlayer insulating layers 120a of the first stack structure GS1 and second interlayer insulating layers 120b of the second stack structure GS2. The interlayer insulating layers 120 may include an insulating material, such as silicon oxide or silicon nitride.

The first stack structure GS1 may include the first interlayer insulating layers 120a and the first gate electrode layers 130a that are alternately stacked on the lower surface of the pattern structure 101, and may further include a connection insulating layer 122 on a lower surface of the lowermost gate electrode layer 130a among the first gate electrode layers 130a. The connection insulating layer 122 may include an insulating material, for example, at least one of silicon oxide, silicon nitride, and silicon oxynitride. The connection insulating layer may include the same material as that of the interlayer insulating layers 120.

The second stack structure GS2 may include the second interlayer insulating layers 120b and second gate electrode layers 130b that are alternately stacked on the lower surface of the first stack structure GS1.

The channel structures CH may be on a lower surface of the first region R1 of the pattern structure 101. Each of the channel structures CH may form a single memory cell string, and the channel structures CH may be spaced apart from each other, while forming rows and columns on the lower surface of the pattern structure 101. The channel structures CH may form a grid pattern in an X-Y plane or may be in a zigzag shape in one or more directions. The channel structures CH may have a hole shape and a pillar shape, and may have inclined sides narrowing toward the pattern structure 101 according to an aspect ratio.

Each of the channel structures CH may pass through the stack structure GS in a Z-direction (e.g., a vertical direction) and may contact the pattern structure 101. In some embodiments, the channel structures CH may extend into the pattern structure 101 to contact an inner portion of the pattern structure 101.

Each of the channel structures CH may include a first channel structure CH1 extending through the first stack structure GS 1 and a second channel structure CH2 extending through the second stack structure GS2. The second channel structure CH2 may extend through the second stack structure GS2 and may be connected to the first channel structure CH1. That is, the first and second channel structures CH1 and CH2 may be connected to each other. Each of the channel structures CH may have a bent portion due to a difference or change in width in a connection region of the first and second channel structures CH1 and CH2. This may be because a width of the lowermost portion of the first channel structure CH1 may be greater than a width of the uppermost portion of the second channel structure CH2.

In some embodiments, some of the channel structures CH may be dummy channels. Also, as illustrated in FIG. 1, dummy channels DCH may be further provided on a lower surface of the second region R2. The dummy channels DCH may have structure similar to(or same as) the channel structures CH.

As illustrated in the cross-sectional view of FIG. 2B and the enlarged view of FIG. 3B, each of the channel structures CH may include a channel layer 140, a channel-filling insulating layer 142 in the channel layer 140, a gate dielectric layer 143 surrounding the channel layer 140, and a channel pad 144.

The channel layer 140 may be formed to have an annular shape that surrounds the internal channel-filling insulating layer 142, but in some embodiments the channel layer 140 may have a columnar shape, such as a column or a prism, without the channel-filling insulating layer 142. Thus in some embodiments the channel-filling insulating layer 142 may be omitted. The channel layer 140 may be connected to the pattern structure 101 at a lower portion thereof. The channel layer 140 may include a semiconductor material, such as polycrystalline silicon or single crystal silicon, and the semiconductor material may be an undoped material or a material including P-type or N-type impurities.

The gate dielectric layer 143 may be between the gate electrode layers 130 and the channel layer 140. The gate dielectric layer 143 may include a tunneling layer 143-1, a charge storage layer 143-2, and a blocking layer 143-3 that are sequentially stacked from the channel layer 140. The tunneling layer 143-1 may tunnel charges into the charge storage layer 143-2 and may include, for example, silicon oxide (SiO₂), silicon nitride (Si₃N₄), silicon oxynitride (SiON), or combinations thereof. The charge storage layer 143-2 may be a charge trap layer or a floating gate conductive layer. The blocking layer 143-3 may include silicon oxide (SiO₂), silicon nitride (Si₃N₄), silicon oxynitride (SiON), a high-k dielectric material, or combinations thereof.

The channel pad 144 may be provided only at a lower end of the second channel structure CH2 in each of the channel structures CH. However, according to some embodiments, each of the first and second channel structures CH1 and CH2 may include a channel pad 144, and in this case, the channel pad 144 of the first channel structure CH1 may be connected to the channel layer 140 of the second channel structure CH2. The channel pad 144 may cover a lower surface of the channel-filling insulating layer 142 and may be electrically connected to the channel layer 140. The channel pad 144 may include, for example, doped polycrystalline silicon.

The channel layer 140, the gate dielectric layer 143, and the channel-filling insulating layer 142 may be connected to each other between the first channel structure CH1 and the second channel structure CH2.

As illustrated in the enlarged view of FIG. 3B, each of the channel structures CH may extend into the pattern structure 101 through the stack structure GS. An upper end of the channel layer 140 may directly contact the pattern structure 101. The upper end of the channel layer 140 may refer to a region adjacent to a portion in which the channel structures CH extend into the pattern structure 101. The gate dielectric layer 143 may surround a lower end (or non-upper end) of the channel layer 140.

The separation structures MS may pass through the stack structure GS and may separate portions of the stack structure GS from each other in the Y-direction (e.g., space apart the portions in the Y-direction). The stack structure GS may include a plurality of stack portions spaced apart from each other by the separation structures MS in the Y-direction. The separation structures MS may include first and second separation structures MS1, MS2a, and MS2b provided in parallel to each other. The first and second separation structures MS1, MS2a, and MS2b may pass through the gate electrode layers 130 (e.g., an entirety of the gate electrodes layer 130) stacked on the pattern structure 101 and may be connected to the pattern structure 101. As seen in FIG. 1, the first separation structures MS1 may extend in one layer (e.g., continuously) in the X-direction, and the second separation structures MS2a and MS2b may intermittently extend between the pair of first separation structures MS1 or may be arranged only in a partial region. In greater detail, the second separation structures MS2a and MS2b may include second central separation structures MS2a and second auxiliary separation structures MS2b between the first separation structures MS1 and the second separation structures MS2a. The second central separation structures MS2a may be provided over the first region R1 and the second region R2, and the second auxiliary separation structures MS2b may be provided only in the second region R2. The second central separation structures MS2a may be spaced apart from each other in the X-direction in the second region R2. According to some embodiments, a shape in which the second separation structures MS2a and MS2b are spaced apart from each other in the second region R2 may be variously changed. In addition, according to some embodiments, the arrangement order and number of the first and second separation structures MS1, MS2a, and MS2b are not limited to those illustrated in FIG. 1.

In some embodiments, each of the separation structures MS may include a first portion MS_P1 passing through the stack structure GS and a second portion MS_P2 extending vertically from the first portion MS_P1 and passing through the pattern structure 101. The first portion MS_P1 and the second portion MS_P2 may be integrally connected. Each of the separation structures MS may include an insulating material continuously extending in the first portion MS_P1 and the second portion MS_P2, and the insulating material may include at least one of silicon oxide, silicon nitride, or silicon carbide.

The first portion MS_P1 may extend in a first horizontal direction, for example, the X-direction. In a second horizontal direction that is perpendicular to the first horizontal direction, for example, in the Y-direction, the first portion MS_P1 may have a width decreasing from the first semiconductor structure S1 toward the pattern structure 101, as best seen in FIG. 3A. Accordingly, the first portion MS_P1 may have a side inclined to increase in width toward the first semiconductor structure S1.

In the second horizontal direction, the second portion MS_P2 may have a width that increases in a direction from the first semiconductor structure S1 toward the pattern structure 101, as best seen in FIG. 3A. Accordingly, the second portion MS_P2 may have a side inclined to decrease in width toward the first semiconductor structure S1.

Each of the separation structures MS may further include a bent portion MS_BP defined by the first portion MS_P1 and the second portion MS_P2. The bent portion MS_BP may be located in a portion in which the first portion MS_P1 and the second portion MS_P2 are connected. Stated differently, sidewalls of the first portion MS_P1 and the second portion MS_P2 may be discontinuous at the bent portion MS_BP. A first width of an upper end of the first portion MS_P1 in the second horizontal direction may be smaller than a second width of a lower end of the second portion MS_P2 in the second horizontal direction. Accordingly, the bent portion MS_BP may be formed between the upper end of the first portion MS_P1 and the lower end of the second portion MS_P2. This may be a structure in consideration of a process margin of an opening forming process performed to expose the first portion MS_P1 after a bonding process between the first and second semiconductor structures S1 and S2. The bent portion MS_BP may be located on a level higher than that of the upper surface of the uppermost gate electrode layer 130 among the gate electrode layers 130. For example, the bent portion MS_BP may be located on substantially the same level as that of the lower surface of the pattern structure 101.

In some embodiments, the semiconductor device 100 may further include a spacer layer 105 that separates the second portion MS_P2 of the separation structures MS and the pattern structure 101. The spacer layer 105 may surround an outer surface of the second portion MS_P2. The spacer layer 105 may be configured to prevent defects occurring in the pattern structure 101 in or during a process of removing the sacrificial insulating layers 118 after forming an opening corresponding to the second portion MS_P2. A lower end of the spacer layer 105 may be located on a level adjacent to a level on which the bent portion MS_BP is located.

The spacer layer 105 may include an oxide-based material, such as silicon oxide or a nitride-based material.

As illustrated in FIG. 1, in the first region R1, the upper separation structures SS may extend between the first separation structure MS1 and the second central separation structure MS2a and between the second central separation structures MS2a in the X-direction. The upper separation structures SS may pass or extend through a portion of the gate electrode layers 130 including the lowermost upper gate electrode layer 130U among the gate electrode layers 130. As illustrated in FIG. 2B, the upper separation structures SS may separate a total of three gate electrode layers 130 including the upper gate electrode layers 130U from each other in the Y-direction. However, the number of gate electrode layers 130 separated by the upper separation structures SS may be variously changed according to various embodiments. The upper gate electrode layers 130U separated by the upper separation structures SS may form different string selection lines. The upper separation structures SS may include an insulating material, for example, silicon oxide, silicon nitride, or silicon oxynitride.

The cell region insulating layer 190 may cover the pattern structure 101 and the gate electrode layers 130 on a lower surface of the pattern structure 101. The cell region insulating layer 190 may be formed of an insulating material, and may include, for example, at least one of silicon oxide, silicon nitride, and silicon oxynitride. According to some embodiments, the cell region insulating layer 190 may include a plurality of insulating layers.

The upper insulating layer 199 may be on the upper surface of the pattern structure 101. The upper insulating layer 199 may function as a passivation layer and/or may protect the semiconductor device 100. In some embodiments, the upper insulating layer 199 may have openings in partial regions, thereby defining a pad region providing connections to and/or from an external device. In the semiconductor device 100, the upper insulating layer 199 may include at least one of silicon oxide, silicon nitride, and silicon carbide.

In some embodiments, the upper end of the spacer layer 105 may be located on a level higher than that of the upper surface of the pattern structure 101. The second portion MS_P2 of each of the separation structures MS may pass through the pattern structure 101 and the upper insulating layer 199, and the spacer layer 105 may separate the second portion MS_P2 and the upper insulating layer 199. That is, the spacer layer 105 may extend from between the second portion MS_P2 and the pattern structure 101 to between the second portion MS_P2 and the upper insulating layer 199.

The upper wiring structures 160, 165, 167, 170, and 180 may include the gate contacts 160, the substrate contact 165, the I/O contact 167, the cell contact plugs 170, and cell wiring lines 180, and may be configured so that the second semiconductor structure S2 is electrically connected to the first semiconductor structure S1.

The gate contacts 160 may pass through the cell region insulating layer 190 and may be connected to the gate electrode layers 130. The gate contacts 160 may include, for example, at least one of tungsten (W), copper (Cu), aluminum (Al), and alloys thereof. According to some embodiments, the gate contacts 160 may further include a barrier layer covering sidewalls and upper surfaces of the contact holes in which the gate contacts 160 are provided. The barrier layer may include, for example, at least one of titanium (Ti), titanium nitride (TiN), tantalum (Ta), and tantalum nitride (TaN).

In some embodiments, the gate contacts 160 may pass through the lowermost gate electrode layers 130 and an insulating structure 125 thereon and may be connected to the gate pad regions 130P of the gate electrode layers 130 in the second region R2. That is, each of the gate contacts 160 may pass through the gate pad region 130P of the gate electrode layer 130 and the insulating structure 125 on the gate pad region 130P. The gate contacts 160 may pass through the stack structure GS to partially extend into the lower surface of the pattern structure 101.

The insulating structure 125 may be alternately arranged with the interlayer insulating layer 120 and may surround the gate contacts 160. The insulating structure 125 may be on the gate pad regions 130P and may surround side surfaces of the gate contacts 160. An inner surface of the insulating structure 125 may surround the gate contacts 160, and an outer surface of the insulating structure 125 may be surrounded by the gate electrode layers 130. The gate contacts 160 may be physically and electrically connected to one gate electrode layer 130 through the insulating structure 125, and may be electrically separated from the gate electrode layers 130 thereon.

In some embodiments, the semiconductor device 100 may further include a contact spacer 103 physically separating and electrically separating the pattern structure 101 from the gate contacts 160. In FIG. 2B, the contact spacer 103 is illustrated in the form of a liner extending with a substantially uniform thickness between the pattern structure 101 and the gate contacts 160, but the shape of the contact spacer 103 may be variously changed. The gate contacts 160 may be electrically separated from the pattern structure 101 by the contact spacer 103.

In some embodiments, a lower surface of each of the gate contacts 160 may be at substantially the same level as that of a lower surface of each of the channel structures CH. This may be because contact holes for forming the gate contacts 160 are formed together in a channel hole forming process for forming the channel structures CH. However, according to some embodiments, the lower surface of each of the gate contacts 160 may be at a level lower than that of the lower surface of each of the channel structures CH.

The substrate contact 165 may be spaced apart from the stack structure GS and may be connected to the pattern structure 101 through the cell region insulating layer 190.

The I/O contact 167 may be spaced apart from the stack structure GS and may pass through the cell region insulating layer 190. The I/O contact 167 may be a contact structure electrically connecting the semiconductor device 100 and an external pad structure. The external pad structure may be a structure that electrically connects the semiconductor device 100 to an external device or is configured to provide such an electrical connection.

In some embodiments, the external pad structure may include a conductive pad 106, a landing pad 108, and a pad spacer 107. The conductive pad 106 may be on the upper insulating layer 199, the landing pad 108 may pass through the upper insulating layer 199 and the pattern structure 101, and may contact the conductive pad 106. The landing pad 108 may include at least one of a conductive material, for example, a metal nitride (e.g., TiN, TaN, or WN, etc.) or a metal (e.g., W, Cu or Al, etc.). The pad spacer 107 may surround an outer surface of the landing pad 108. However, according to some embodiments, the pad spacer 107 may include a portion that extends between the landing pad 108 and the cell region insulating layer 190 along the outer surface of the landing pad 108. The pad spacer 107 may include an insulating material, such as silicon oxide. The landing pad 108 may be electrically spaced apart from the pattern structure 101 by the pad spacer 107. The I/O contact 167 may pass through the cell region insulating layer 190 to contact the landing pad 108.

An upper surface of the landing pad 108 may be located on substantially the same level as or higher than that of an upper surface of the second portion MS_P2 of each of the separation structures MS. This may be because the landing pad 108 is formed after the separation structures MS are formed.

The cell contact plugs 170 may include first to third cell contact plugs 172, 174, and 176, and the cell wiring lines 180 may include first and second cell wiring lines 182 and 184. The channel pad 144, the gate contacts 160, the substrate contact 165, and the I/O contact 167 may be connected to the first cell contact plugs 172 at a lower end. The first cell contact plugs 172 may be connected to the second cell contact plugs 174 at a lower end, and the second cell contact plugs 174 may be connected to the first cell wiring lines 182 at a lower end. The third cell contact plugs 176 may vertically connect the first and second cell wiring lines 182 and 184 to each other. The cell contact plugs 170 may have a cylindrical shape. The cell contact plugs 170 may have different lengths. For example, the first cell contact plugs 172 may have a relatively longer length. According to some embodiments, the cell contact plugs 170 may have side surfaces that narrow in width (in the X-direction) toward the pattern structure 101 and increasing in width (in the X-direction) toward the first semiconductor structure S 1 according to an aspect ratio. According to some embodiments, some of the cell contact plugs 170 may be dummy contact plugs to which an electrical signal is not applied.

The first cell wiring lines 182 may include the bit lines of the first region R1 connected to the channel structures CH and the wiring lines of the second region R2 at the same height as that of the bit lines. The second cell wiring lines 184 may be wiring lines below the first cell wiring lines 182. The cell wiring lines 180 may have a line shape that extend in at least one horizontal direction. According to embodiments, the second cell wiring lines 184 may have a thickness that is greater than that of the first cell wiring lines 182. The cell wiring lines 180 may have inclined side surfaces narrowing in width toward the pattern structure 101.

The gate contacts 160, the substrate contact 165, the I/O contact 167, the cell contact plugs 170, and the cell wiring lines 180 may be formed of, for example, tungsten (W) or aluminum (Al), copper (Cu), tungsten nitride (WN), tantalum nitride (TaN), titanium nitride (TiN), or combinations thereof.

The second bonding vias 195 of the upper bonding structures 195 and 198 may be below the second cell wiring lines 184 and may be connected to the second cell wiring lines 184, and the second bonding metal layers 198 of the upper bonding structure 195 and 198 may be connected to the second bonding vias 195. A lower surface of the second bonding metal layers 198 may be exposed to a lower surface of the second semiconductor structure S2. The second bonding metal layers 198 may be bonded to and connected to the first bonding metal layers 298 of the first semiconductor structure S1. The second bonding vias 195 and the second bonding metal layers 198 may include a conductive material, for example, copper (Cu).

According to some embodiments, the cell region insulating layer 190 may include a bonding insulating layer having a predetermined thickness from a lower surface thereof. In some embodiments, the bonding insulating layer may form a dielectric-dielectric bonding with the bonding insulating layer of the first semiconductor structure S1. The bonding insulating layer may include, for example, at least one of SiO, SiN, SiCN, SiOC, SiON, and SiOCN.

The first and second semiconductor structures S1 and S2 may be bonded by bonding the first bonding metal layers 298 and the second bonding metal layers 198 and bonding the bonding insulating layers. The bonding of the first bonding metal layers 298 and the second bonding metal layers 198 may be, for example, a copper (Cu)-copper (Cu) bonding, and the bonding of the bonding insulating layers may be, for example, a dielectric-dielectric bonding, such as a SiCN-SiCN bonding. The first and second semiconductor structures S1 and S2 may be bonded by hybrid bonding including copper (Cu)-copper (Cu) bonding and dielectric-dielectric bonding.

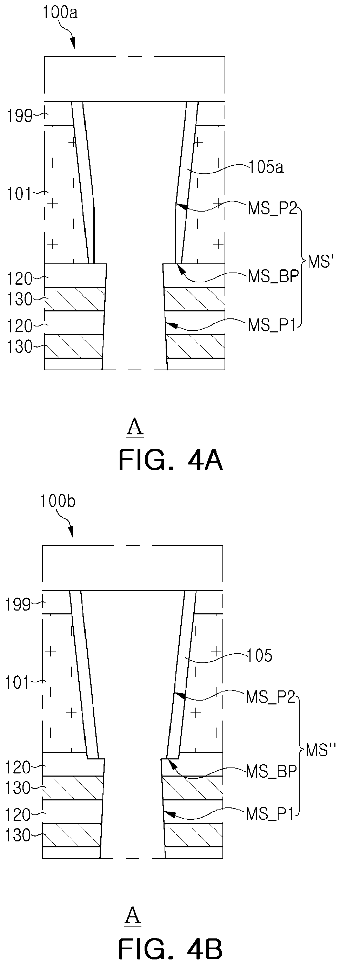

FIG. 4A is a partially enlarged view of a semiconductor device according to some embodiments. FIG. 4A illustrates a region corresponding to the region 'A' of FIG. 2A.

Referring to FIG. 4A, a semiconductor device 100a may include a spacer layer 105a and separation structures MS' that are different from those of FIG. 2A.

In the second horizontal direction, for example, in the Y-direction, the spacer layer 105a may include a portion having a width decreasing downwardly. The structure may be, for example, a structure due to a side surface having a first slope and a side surface having a second slope, but may also be a structure due to a rounded side surface. Accordingly, side surfaces of the second portion MS_P2 in contact with the side surface of the spacer layer 105a may also have a shape other than a straight-line inclined side surface. This may be a structure formed by forming an opening, forming a spacer layer on an outer wall of the opening, and then performing a separate etch-back process.

In the second horizontal direction, as a width of a lower end of the second portion MS_P2 of each of the separation structures MS' is relatively widened, the process difficulty of a subsequent process is improved and the productivity of the semiconductor device 100a may be improved.

FIG. 4B is a partially enlarged view of a semiconductor device according to some embodiments. FIG. 4B illustrates a region corresponding to the region 'A' of FIG. 2A.

Referring to FIG. 4B, a semiconductor device 100b may include a structure of separation structures MS" different from that of FIG. 2A.

The bent portion MS_BP of each of the separation structures MS" may be located on a level lower than that of the lower surface of the pattern structure 101. This may be because a portion of the uppermost interlayer insulating layer 120 is removed according to process conditions of an etching process for forming the opening corresponding to the second portion MS_P2 and the spacer layer 105. Accordingly, a lower end of the spacer layer 105 may extend to a region adjacent to the level on which the bent portion MS_BP is located and the lower end of the spacer layer 105 may be located on a level lower than that of the lower surface of the pattern structure 101.

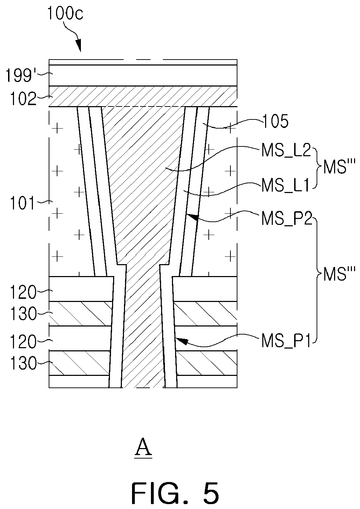

FIG. 5 is a partially enlarged view of a semiconductor device according to some embodiments. FIG. 5 illustrates a region corresponding to the region 'A' of FIG. 2A.

Referring to FIG. 5, a semiconductor device 100c may include a structure of separation structures MS‴ that is different from that of FIG. 2A, and may further include a plate conductive layer 102.

The plate conductive layer 102 may be between the upper insulating layer 199' and the pattern structure 101.

Each of the separation structures MS‴ may include a vertical conductive layer MS_L2 that extends from a lower surface of the plate conductive layer 102 and is integrated with the plate conductive layer 102. An insulating liner MS_L1 may surround an outer surface of the vertical conductive layer MS_L2. The plate conductive layer 102 and the vertical conductive layer MS_L2 may include the same conductive material, for example, doped polycrystalline silicon or a metal (such as W, Cu, or Al). The plate conductive layer 102 and the vertical conductive layer MS_L2 may function as a common source line together with the pattern structure 101 or reduce noise of the common source line.

Each of the separation structures MS‴ may include a first portion MS_P1 and a second portion MS_P2, and each of the vertical conductive layer MS_L2 and the insulating liner MS_L1 may extend within the first portion MS_P1 and the second portion MS_P2.

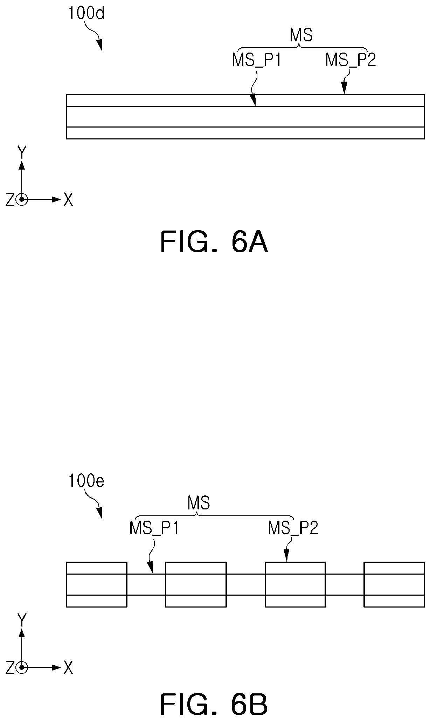

FIGS. 6A and 6B are schematic plan views of semiconductor devices according to some embodiments. FIGS. 6A and 6B are plan views schematically illustrating a separation structure MS among components of a semiconductor device according to some embodiments. The separation structure MS may extend in the first horizontal direction, for example, the X-direction.

Referring to FIG. 6A, the second portion MS_P2 may extend on the first portion MS_P1 in the first horizontal direction. In the second horizontal direction, perpendicular to the first horizontal direction, for example, the Y-direction, a width of the second portion MS_P2 may be greater than a width of the first portion MS_P1. Accordingly, in plan view, the entire first portion MS_P1 may overlap the second portion MS_P2.

Referring to FIG. 6B, the second portion MS_P2 may be a plurality of patterns that may be spaced apart from each other on the first portion MS_P1, unlike FIG. 6A. That is, the first portion MS_P1 may have a line shape (e.g., a continuous line shape) extending in the first horizontal direction, and the second portion MS_P2 may have a pattern shape that intermittently extend in the first horizontal direction on the first portion MS_P1.

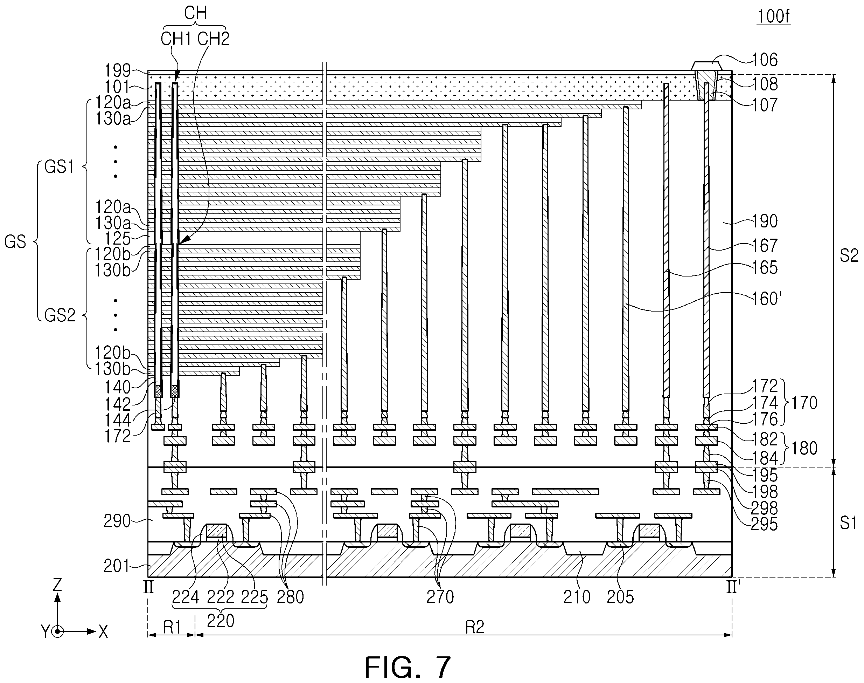

FIG. 7 is a schematic cross-sectional view of a semiconductor device according to some embodiments.

Referring to FIG. 7, a semiconductor device 100f may include gate contacts 160' that are different from those of FIG. 2A.

The gate contacts 160' may be electrically connected to the gate electrode layer 130 by passing through the cell region insulating layer 190 and may in contact with the gate electrode layers 130 in which lower surfaces are exposed. Upper surfaces of the gate contacts 160' may be on the gate electrode layers 130 in which lower surfaces are exposed. That is, the gate contacts 160' may not extend into the pattern structure 101 through the stack structure GS.

The semiconductor device 100f may not include the contact spacer 103 and/or the insulating structure 125 of FIG. 2A.

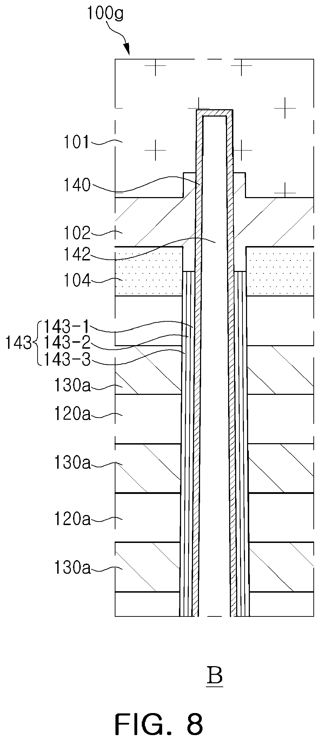

FIG. 8 is a partially enlarged view of a semiconductor device 100g according to some embodiments. FIG. 8 illustrates a region corresponding to the region 'B' of FIG. 2B.

Referring to FIG. 8, a semiconductor device 100g may further include first and second horizontal conductive layers 102 and 104 between the pattern structure 101 and the gate electrode layers 130a and 130b.

The first and second horizontal conductive layers 102 and 104 may be sequentially stacked and on the lower surface of the first region R1 (refer to FIG. 2A) of the pattern structure 101. The first horizontal conductive layer 102 may not extend to the second region R2 of the pattern structure 101, and the second horizontal conductive layer 104 may extend to the second region R2.

The first horizontal conductive layer 102 may function as part of the common source line of the semiconductor device 100e, for example, as a common source line together with the pattern structure 101. The first horizontal conductive layer 102 may be directly connected to the channel layer 140 around the channel layer 140.

The second horizontal conductive layer 104 may contact the pattern structure 101 in partial regions in which the first horizontal conductive layer 102 is not provided. The second horizontal conductive layer 104 may cover an end portion of the first horizontal conductive layer 102 in the partial regions and may be bent to extend onto the pattern structure 101.

The first and second horizontal conductive layers 102 and 104 may include a semiconductor material, for example, both the first and second horizontal conductive layers 102, 104 may include polycrystalline silicon. In this case, at least the first horizontal conductive layer 102 may be a doped layer, and the second horizontal conductive layer 104 may be a doped layer or a layer including impurities diffused from the first horizontal conductive layer 102. However, according to some embodiments, the second horizontal conductive layer 104 may be replaced with an insulating layer.

The semiconductor device 100g may further include a horizontal insulating layer on the lower surface of the pattern structure 101 in parallel to the first horizontal conductive layer 102 in at least a portion of the second region R2 (refer to FIG. 2B). The horizontal insulating layer may include first to third horizontal insulating layers alternately stacked on the lower surface of the pattern structure 101. The horizontal insulating layers may be layers that remain after part of the horizontal insulating layer is replaced with the first horizontal conductive layer 102 in the manufacturing process of the semiconductor device. The horizontal insulating layer may include silicon oxide, silicon nitride, silicon carbide, or silicon oxynitride.

In an embodiment, the gate dielectric layer 143 may surround the side surface of the channel layer 140 below the first horizontal conductive layer 102 as illustrated in FIG. 8, but is not limited thereto. In this case, the gate dielectric layer 143 may be disposed on the first horizontal conductive layer 102 to cover both the side surface and the upper surface of the channel layer 140 together.

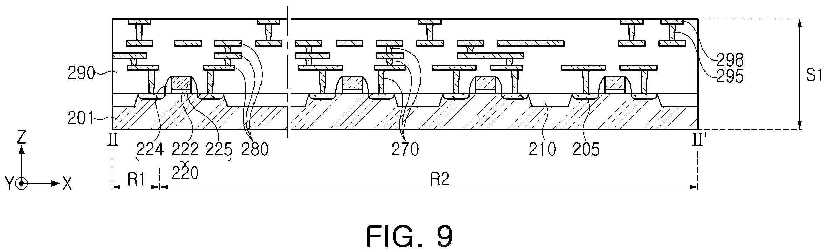

FIGS. 9 to 15 are schematic views illustrating a method of manufacturing a semiconductor device according to some embodiments.

FIGS. 9, 10A, 11, and 12A are cross-sectional views corresponding to FIG. 2B, and FIGS. 10B, 12B, 13, 14, and 15 are cross-sectional views corresponding to FIG. 2A.

Referring to FIG. 9, the first semiconductor structure S1 including circuit elements 220, lower wiring structures 270 and 280, and lower bonding structures 295 and 298 may be formed on a lower substrate 201.

First, the device separation layers 210 may be formed in the lower substrate 201, and the circuit gate dielectric layer 222 and the circuit gate electrode layer 225 may be sequentially formed on the lower substrate 201. The device separation layers 210 may be formed by, for example, a shallow trench separation (STI) process. The circuit gate dielectric layer 222 and the circuit gate electrode layer 225 may be formed using atomic layer deposition (ALD) or chemical vapor deposition (CVD). The circuit gate dielectric layer 222 may be formed of silicon oxide, and the circuit gate electrode layer 225 may be formed of at least one of polycrystalline silicon or a metal silicide layer, but the present disclosure is not limited thereto. Next, the spacer layer 224 and the source/drain regions 205 may be formed on both sidewalls of the circuit gate dielectric layer 222 and the circuit gate electrode layer 225. According to some embodiments, the spacer layer 224 may be formed of a plurality of layers. Next, the source/drain regions 205 may be formed by performing an ion implantation process.

The circuit contact plugs 270 of the lower wiring structures 270 and 280 and the first bonding vias 295 of the lower bonding structures 295 and 298 may be formed by forming a portion of the peripheral region insulating layer 290, then etching and removing a portion of the peripheral region insulating layer 290, and then filling a removed portion with a conductive material. The circuit wiring lines 280 of the lower wiring structures 270 and 280 and the first bonding metal layers 298 of the lower bonding structures 295 and 298 may be formed by, for example, depositing a conductive material and then patterning the conductive material. The first bonding metal layers 298 may be formed such that upper surfaces thereof are exposed through the peripheral region insulating layer 290.

The peripheral region insulating layer 290 may include a plurality of insulating layers. A portion of the peripheral region insulating layer 290 may be formed in each of the operations of forming the lower wiring structures 270 and 280 and the lower bonding structures 295 and 298. By this operation, the first semiconductor structure S1 may be prepared.

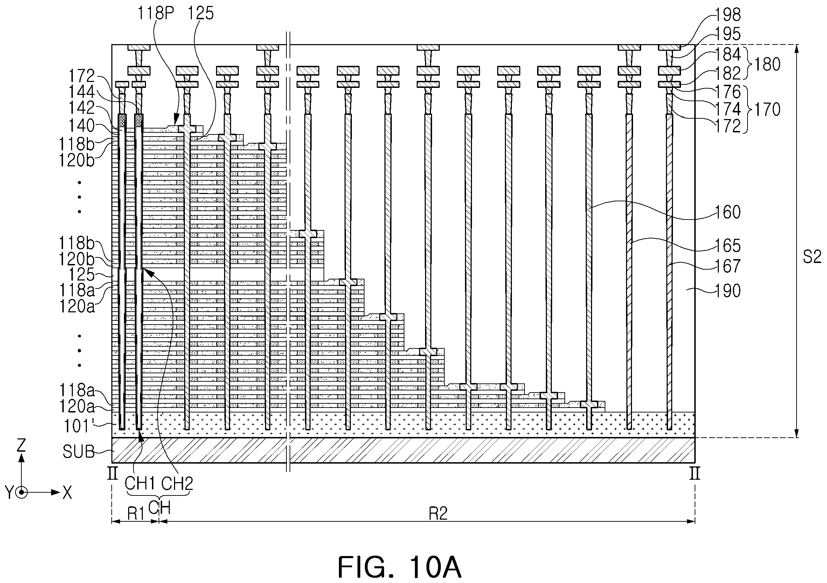

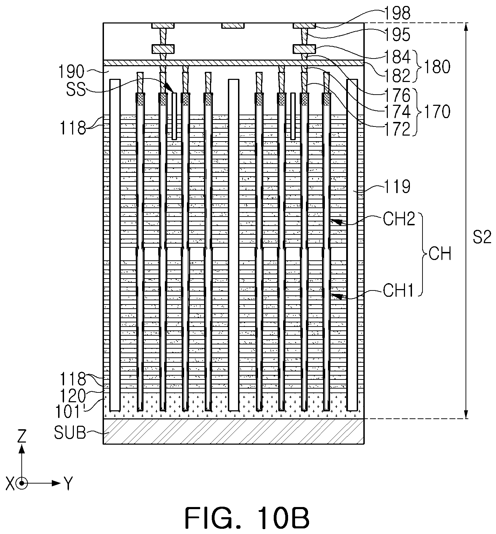

Referring to FIGS. 10A and 10B, a manufacturing process of the second semiconductor structure S2 may be started. First, a preliminary substrate 101' may be formed on the base substrate SUB, a preliminary stack structure may be formed that includes sacrificial insulating layers 118a alternately stacked with interlayer insulating layers 120a and sacrificial insulating layers 118b alternately stacked with interlayer insulating layers 120b , and thereafter, the channel structures CH that pass or extend through the preliminary stack structure, preliminary separation structures 119, the upper wiring structures 160, 165, 167, 170, and 180, and the upper bonding structures 196 and 198 may be formed.

The base substrate SUB may be a layer that is removed through a subsequent process, and may be a semiconductor substrate, such as silicon (Si). The preliminary substrate 101' may be a layer removed through a subsequent process, and may be formed of, for example, a polycrystalline silicon layer or an epitaxial layer. In some embodiments, the preliminary substrate 101' may be formed of a polycrystalline silicon layer and may be free from impurities (e.g., may not include impurities). However, according to some embodiments, the subsequent process may be performed using a single substrate by omitting the base substrate SUB or the preliminary substrate 101'.

Next, the preliminary stack structure may be formed by alternately depositing the interlayer insulating layers 120a and 120b and the sacrificial insulating layers 118a and 118b on the preliminary substrate 101'. The preliminary stack structure may include a first preliminary stack structure including first interlayer insulating layers 120a and first sacrificial insulating layers 118a, and a second preliminary stack structure including second interlayer insulating layers 120b and second sacrificial insulating layers 118b. The sacrificial insulating layers 118a and 118b may be replaced by the gate electrode layers 130 through a subsequent process. The sacrificial insulating layers 118a and 118b may be formed of a material that may be etched with etch selectivity under specific etching conditions with respect to the interlayer insulating layers 120a and 120b under specific etching conditions. For example, the interlayer insulating layers 120a and 120b may be formed of at least one of silicon oxide and silicon nitride, and the sacrificial insulating layers 118a and 118b may be formed of a material different from that of the insulating layers 120a and 120b selected from among silicon, silicon oxide, silicon carbide, and silicon nitride. According to embodiments, thicknesses of the interlayer insulating layers 120a and 120b may not all be the same.

The cell region insulating layer 190 that covers the preliminary stack structure may be formed, and a portion of the second preliminary stack structure may be removed to form the upper separation structures SS. The upper separation structures SS may be formed by exposing a region in which the upper separation structures SS are to be formed using a separate mask layer, removing a predetermined number of sacrificial insulating layers 118 and interlayer insulating layers 120 from the top, and then depositing an insulating material.

Channel holes that pass through the preliminary stack structure and expose the preliminary substrate 101' may be formed by performing an anisotropic etching process, and the channel structures CH may be formed by sequentially depositing the gate dielectric layer 143 (refer to FIG. 3B), the channel layer 140, the channel-filling insulating layer 142, and the channel pad 144 in the channel hole. In some embodiment, the channel holes may be formed by forming a channel sacrificial layer in a first channel hole that passes through the first preliminary stack structure and removing the channel sacrificial layer through the second channel hole passing through the second preliminary stack structure, but the method of forming the channel holes is not limited thereto. In the channel hole, the tunneling layer 143-1 (refer to FIG. 3B), the information storage layer 143-2 (refer to FIG. 3B), and the blocking layer 143-3 (refer to FIG. 3B) may be sequentially deposited by performing a deposition process to form the gate dielectric layer 143 (refer to FIG. 3B). For example, the deposition process may include an atomic layer deposition (ALD) process or a chemical vapor deposition (CVD) process.

The gate contacts 160, the substrate contact 165, and the I/O contact 167 of the upper wiring structures 160, 165, 167, 170, and 180 are formed by forming contact holes by etching the cell region insulating layer 190 on the preliminary substrate 101' and filling the contact holes with a conductive material.

The gate contacts 160 may be formed by forming openings passing through the preliminary stack structure, forming tunnel portions by removing a portion of the sacrificial insulating layers 118 exposed through the openings, forming the insulating structure 125 in the remaining regions excluding the sacrificial gate pad region 118P, among the tunnel portions, and then filling with a conductive material. In some embodiments, the openings may be formed together with the channel hole. In this case, the gate contacts 160 may have upper surfaces on substantially the same level as that of the channel structures CH. However, according to embodiments, the structure and manufacturing method of the gate contacts 160 may be variously changed.

The substrate contact 165 and the I/O contact 167 may be formed by filling the contact holes passing through the cell region insulating layer 190 to expose the preliminary substrate 101' with a conductive material. The contact holes may be spaced apart from the preliminary stack structure.

Next, the cell region insulating layer 190 may be further formed, openings passing through the preliminary stack structure may be formed by performing an etching process, and a material including at least one of a semiconductor material, such as polycrystalline silicon, oxide, or nitride may be deposited in the openings to form the preliminary separation structures 119. The preliminary separation structures 119 may include a region corresponding to the first portion MS_P1 (refer to FIG. 2A) of the separation structures MS (refer to FIG. 1). That is, the preliminary separation structures 119 may be formed in a trench form extending in the first horizontal direction, for example, the X-direction.

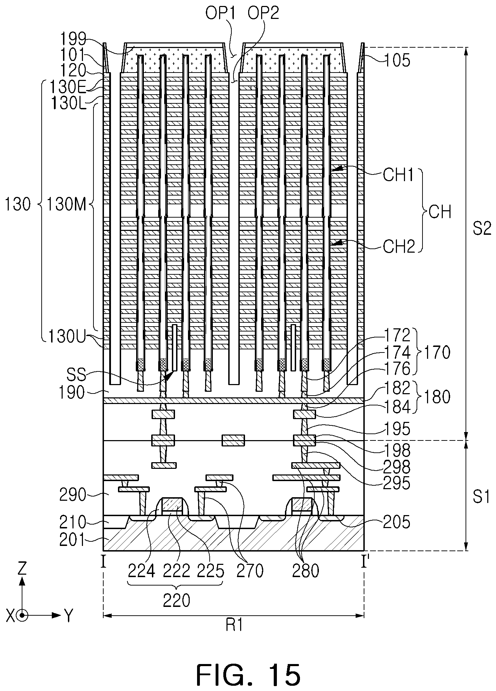

Next, cell contact plugs 170 and cell wiring lines 180 among the upper wiring structures 160, 165, 167, 170 and 180 may be formed on the preliminary stack structure, and the upper bonding structures 195 and 198 may be formed. The cell contact plugs 170 may be formed by etching the cell region insulating layer 190 and depositing a conductive material on the channel pad 144, the gate contacts 160, the substrate contact 165, and the I/O contact 167. The cell wiring lines 180 may be formed in a process of depositing and patterning a conductive material, or may be formed by partially forming an insulating layer constituting the cell region insulating layer 190, patterning the same, and depositing a conductive material. In this process, the cell contact plugs 170 and the cell wiring lines 180 may be formed without performing the process of forming the gate electrode layers 130 (refer to FIG. 15), and thus, process difficulty may be improved. As the gate electrode layers 130 are formed, tensile stress may be applied to the stack structure to cause warpage of the stack structure. However, according to the present embodiments, process defects that may occur due to the warping phenomenon, for example, defects that result in the cell contact plugs 170 being misaligned and not connected to the channel pad 144, etc. may be suppressed, so that a semiconductor device having improved productivity may be provided.

The second bonding vias 195 and the second bonding metal layers 198 may be formed by further forming the cell region insulating layer 190 on the cell wiring lines 180, removing portions thereof, and then depositing a conductive material. Upper surfaces of the second bonding metal layers 198 may be exposed from the cell region insulating layer 190.

In the present specification, the second semiconductor structure S2 after the process operations described above with reference to FIGS. 10A and 10B during the manufacturing process of the second semiconductor structure S2 may be referred to as a "second preliminary semiconductor structure".

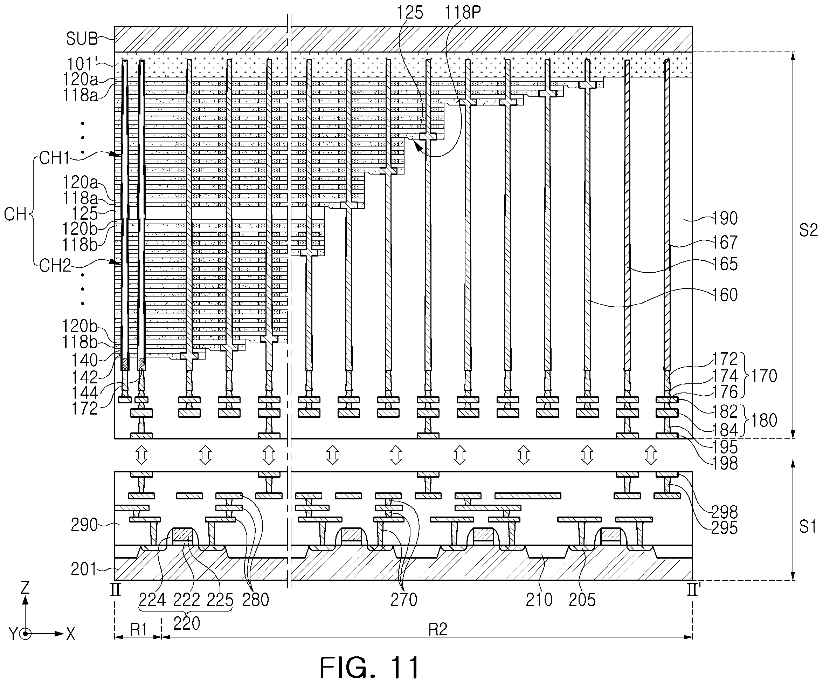

Referring to FIG. 11, the first semiconductor structure S1 and the second semiconductor structure S2 may be bonded.

The first semiconductor structure S1 and the second semiconductor structure S2 may be connected by bonding the first bonding metal layers 298 and the second bonding metal layers 198 by pressure. At the same time, bonding insulating layers that are part of the peripheral region insulating layer 290 and the cell region insulating layer 190 may be bonded by pressing. After the second semiconductor structure S2 is turned over on the first semiconductor structure S1 so that the second bonding metal layers 198 face downwardly, bonding may be performed. In the drawings, for better understanding, the second semiconductor structure S2 is illustrated to be bonded in a mirror image of the structure illustrated in FIG. 10A.

The first semiconductor structure S1 and the second semiconductor structure S2 may be directly bonded without intervening of an adhesive, such as a separate adhesive layer. According to embodiments, before bonding, a surface treatment process, such as hydrogen plasma treatment, may be further performed on the upper surface of the first semiconductor structure S 1 and the lower surface of the second semiconductor structure S2 in order to strengthen bonding strength.

In this process, since the first semiconductor structure S1 and the second semiconductor structure S2 are bonded without forming the gate electrode layers 130 (refer to FIG. 15), the process difficulty of the bonding process may be improved. As the sacrificial insulating layers 118a and 118b are removed and replaced with the gate electrode layers 130, warpage of the base substrate SUB or the preliminary substrate 101' may occur. However, since the bonding process is performed while the sacrificial insulating layers 118a and 118b are included, a process defect caused by the warpage may be improved. Accordingly, a semiconductor device having improved productivity may be provided.

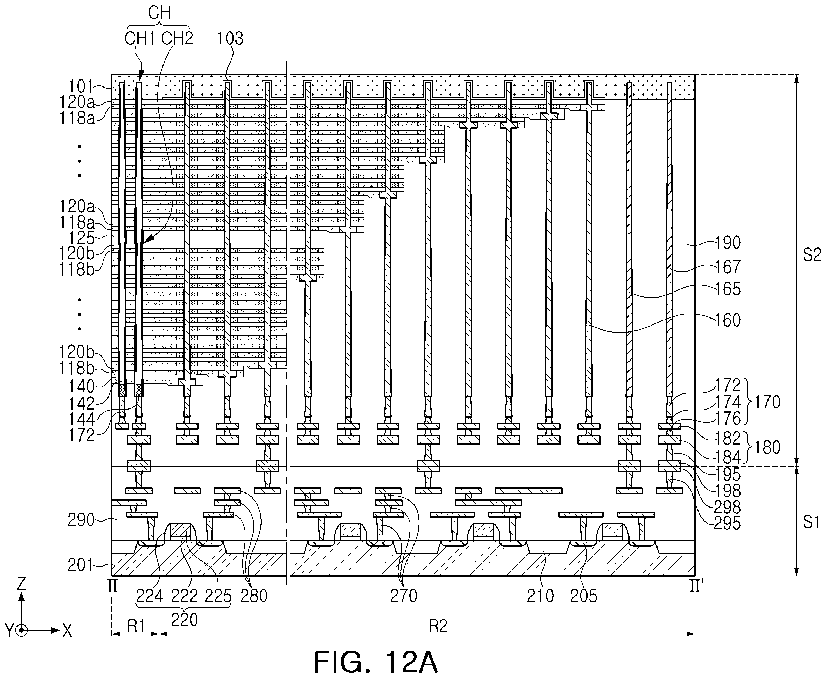

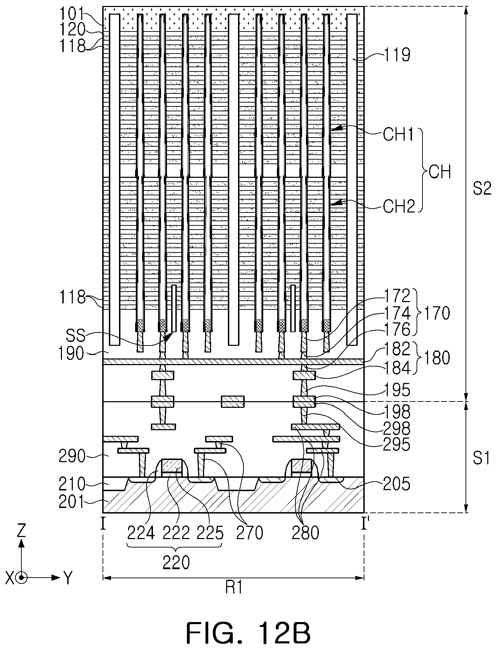

Referring to FIGS. 12A and 12B, the base substrate SUB and the preliminary substrate 101' may be removed, the contact spacers 103 may be formed, and the pattern structure 101 may be formed.

The base substrate SUB and the preliminary substrate 101' may be selectively removed by a polishing process, such as a grinding process, and the channel layer 140 may be exposed by selectively performing an etching process on the gate dielectric layer 143 exposed as the preliminary substrate 101' is removed. Next, the contact spacer 103 may be formed to cover the gate contacts 160 that are exposed as the preliminary substrate 101' is removed, but the structure and method of forming the contact spacer 103 may be variously changed.

The pattern structure 101 that covers the channel layer 140 and the uppermost interlayer insulating layer 120a may be formed. The pattern structure 101 may include a semiconductor material, for example, polycrystalline silicon. In some embodiments, the pattern structure 101 may include impurities.

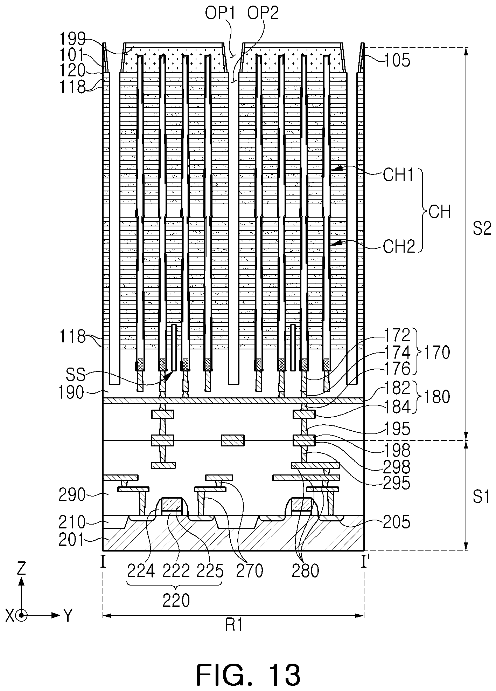

Referring to FIG. 13, an upper insulating layer 199 may be formed on the pattern structure 101, and first and second openings OP1 and OP2 may be formed.

The upper insulating layer 199 may be formed by depositing an insulating material layer having a uniform or conformal thickness on the pattern structure 101.

The first openings OP1 that pass through the pattern structure 101 and expose upper surfaces of the preliminary separation structures 119 may be formed by performing an etching process.

In some embodiments, a portion of the uppermost interlayer insulating layer 120a may be removed together with the pattern structure 101 through the etching process. In this case, the semiconductor device 100b of FIG. 4B may be provided.

In some embodiments, each of the first openings OP1 may be formed to have a line shape (i.e., a trench shape) that extends in the first horizontal direction (X-direction) on the preliminary separation structures 119. In this case, the semiconductor device 100d of FIG. 6A may be provided. However, according to some embodiments, each of the first openings OP1 may be formed to have a pattern shape that intermittently extends in the first horizontal direction on the preliminary separation structures 119. In this case, the semiconductor device 100e of FIG. 6B may be provided.

Next, returning to FIG. 13, the spacer layer 105 covering the side surface of the pattern structure 101 exposed by the first opening OP1 may be formed. In some embodiments, the spacer layer 105 may be formed by performing an oxidation process on the side surface of the pattern structure 101, but according to other embodiments, the spacer layer 105 may also be formed by performing a deposition process of depositing an oxide layer on the side surface of the pattern structure 101. In some embodiments, before performing the deposition process, an etch-back process of lowering a height of the upper surfaces of the preliminary separation structures 119 by a predetermined height may be additionally performed.

Next, the second openings OP2 may be formed by selectively removing the preliminary separation structures 119 exposed by the first openings OP1.

The first openings OP1 may correspond to the second portion MS_P2 (refer to FIG. 2A) of the separation structures MS (refer to FIG. 2A) formed through a subsequent process, and the second openings OP2 may a region corresponding to the first portion MS_P1 (refer to FIG. 2A) of the separation structures MS (refer to FIG. 2A) formed through a subsequent process.

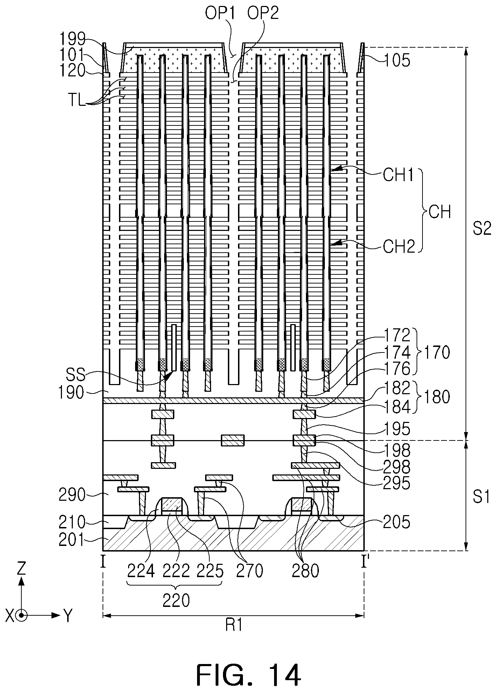

Referring to FIG. 14, the tunnel portions TL may be formed.

The tunnel portions TL may be formed by removing the sacrificial insulating layers 118 exposed by the second openings OP2. The sacrificial insulating layers 118 may be removed by performing an etching process for selectively removing the sacrificial insulating layers 118 with respect to the interlayer insulating layers 120.

Referring to FIG. 15, gate electrode layers 130 may be formed.

The gate electrode layers 130 may be formed by depositing a conductive material in the tunnel portions TL in which the sacrificial insulating layers 118 are removed. In some embodiments, an auxiliary gate dielectric layer may be first formed to cover and/or conform to the interlayer insulating layers 120 before the gate electrode layers 130 are formed, but the present inventive concepts are not limited thereto. The gate electrode layers 130 may be formed by filling the region from which the sacrificial insulating layers 118 are removed and performing an etching process on the conductive material filling the first and second openings OP1 and OP2. The conductive material may include a metal, polycrystalline silicon, or a metal silicide material.

Next, separation structures MS (FIG. 2A) including the first and second portions MS_P1 and MS_P2 may be formed by filling the first and second openings OP1 and OP2 with an insulating material, and external pad structures 106, 107, and 108 may be formed to provide the semiconductor device 100 of FIGS. 1 to 3B.

According to some embodiments, the upper insulating layer 199 may be etched to expose the upper surface of the pattern structure 101, the insulating liner MS_L1 may be formed in the first and second openings OP1 and OP2, and a conductive material may be deposited in first and second openings OP1 and OP2 to form the vertical conductive layer MS_L2 in the separation structures MS, the conductive material may be additionally deposited and a planarization process may be performed to form the plate conductive layer 102, and the upper insulating layer 199' may be additionally formed on the plate conductive layer 102 to provide the semiconductor device 100c of FIG. 5.

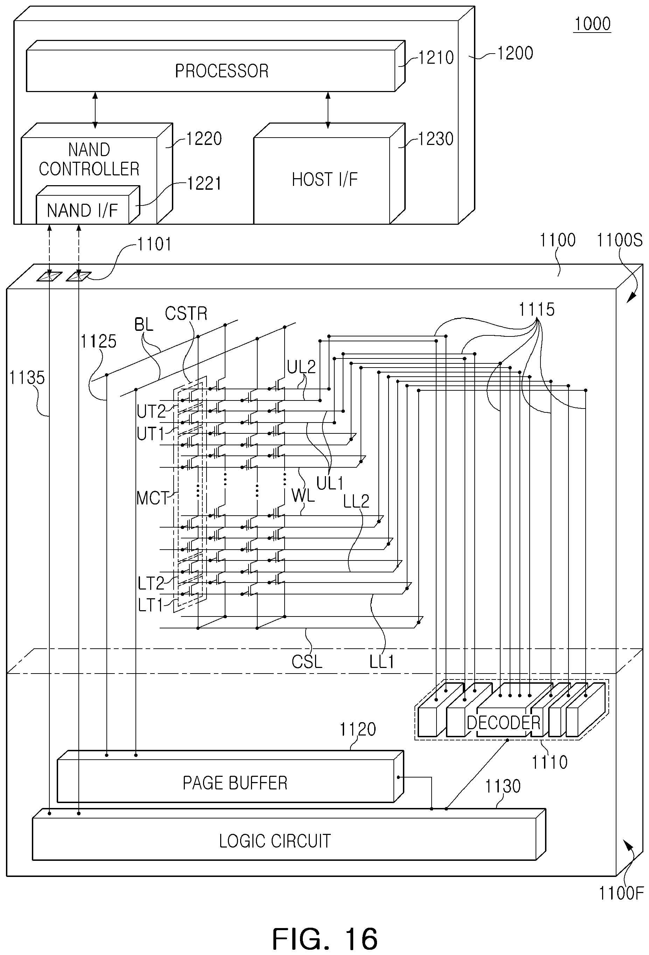

FIG. 16 is a diagram schematically illustrating a data storage system 1000 including a semiconductor device according to some embodiments.

Referring to FIG. 16, the data storage system 1000 may include a semiconductor device 1100 and a controller 1200 electrically connected to the semiconductor device 1100.

The data storage system 1000 may be a storage device including one or a plurality of semiconductor devices 1100, or as an electronic device including a storage device.

For example, the data storage system 1000 may be a solid state drive (SSD) device, a universal serial bus (USB), a computing system, a medical device, or a communication device including one or a plurality of semiconductor devices 1100.

The semiconductor device 1100 may be a nonvolatile memory device and may be, for example, the NAND flash memory device described above with reference to FIGS. 1 to 15. The semiconductor device 1100 may include a first semiconductor structure 1100F and a second semiconductor structure 1100S on the first semiconductor structure 1100F. The first semiconductor structure 1100F may be a peripheral circuit structure including a decoder circuit 1110, a page buffer 1120, and a logic circuit 1130. The second semiconductor structure 1100S may be a memory cell structure including a bit line BL, a common source line CSL, word lines WL, first and second gate upper lines UL1 and UL2, and memory cell strings CSTR between the bit line BL and the common source line CSL.

In the second semiconductor structure 1100S, each of the memory cell strings CSTR may include lower transistors LT1 and LT2 adjacent to the common source line CSL, and upper transistors UT1 and UT2 adjacent to the bit line BL, and a plurality of memory cell transistors MCT between the lower transistors LT1 and LT2 and the upper transistors UT1 and UT2. The number of lower transistors LT1 and LT2 and the number of upper transistors UT1 and UT2 may be variously changed according to embodiments.

In some example embodiments, the upper transistors UT1 and UT2 may include a string select transistor, and the lower transistors LT1 and LT2 may include a ground select transistor. The gate lower lines LL1 and LL2 may be gate electrode layers of the lower transistors LT1 and LT2, respectively. The word lines WL may be gate electrode layers of the memory cell transistors MCT, and the gate upper lines UL1 and UL2 may be gate electrode layers of the upper transistors UT1 and UT2, respectively.

In some example embodiments, the lower transistors LT1 and LT2 may include a lower erase control transistor LT1 and a ground select transistor LT2 connected in series. The upper transistors UT1 and UT2 may include a string select transistor UT1 and an upper erase control transistor UT2 connected in series. At least one of the lower erase control transistor LT1 and the upper erase control transistor UT1 may be used for an erase operation of erasing data stored in the memory cell transistors MCT using a GIDL phenomenon.

The common source line CSL, the first and second gate lower lines LL1 and LL2, the word lines WL, and the first and second gate upper lines UL1 and UL2 may be electrically connected the decoder circuit 1110 through first connection wirings 1115 extending from within the first semiconductor structure 1100F to the second semiconductor structure 1100S. The bit lines BL may be electrically connected to the page buffer 1120 through second connection lines 1125 extending from within the first semiconductor structure 1100F to the second semiconductor structure 1100S.

In the first semiconductor structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through an I/O pad 1101 electrically connected to the logic circuit 1130. The I/O pad 1101 may be electrically connected to the logic circuit 1130 through an I/O connection line 1135 extending from within the first semiconductor structure 1100F to the second semiconductor structure 1100S.

The controller 1200 may include a processor 1210, a NAND controller 1220, and a host interface (I/F) 1230. In some example embodiments, the data storage system 1000 may include a plurality of semiconductor devices 1100, and in this case, the controller 1200 may control the plurality of semiconductor devices 1100.

The processor 1210 may control an overall operation of the data storage system 1000 including the controller 1200. The processor 1210 may operate according to predetermined firmware, and may access the semiconductor device 1100 by controlling the NAND controller 1220. The NAND controller 1220 may include a controller IF (or a NAND I/F) 1221 that handles communication with the semiconductor device 1100. Through the controller I/F 1221, a control command for controlling the semiconductor device 1100, data to be written to the memory cell transistors MCT of the semiconductor device 1100, and data to be read from the memory cell transistors of the semiconductor device 1100 may be transmitted. The host I/F 1230 may provide a communication function between the data storage system 1000 and an external host. When a control command is received from an external host through the host I/F 1230, the processor 1210 may control the semiconductor device 1100 in response to the control command.

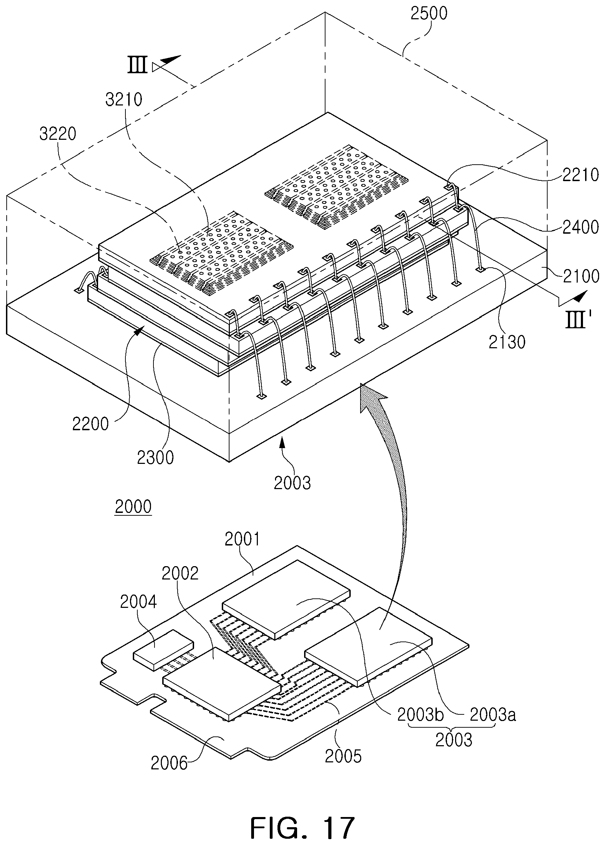

FIG. 17 is a schematic perspective view of a data storage system including a semiconductor device according to some example embodiments.

Referring to FIG. 17, a data storage system 2000 according to some example embodiments of the present inventive concepts may include a main board 2001, a controller 2002 mounted on the main board 2001, one or more semiconductor packages 2003, and DRAM 2004. The semiconductor package 2003 and the DRAM 2004 may be connected to the controller 2002 by wiring patterns 2005 formed on the main board 2001.

The main board 2001 may include a connector 2006 including a plurality of pins coupled to an external host. The number and arrangement of the plurality of pins in the connector 2006 may vary depending on a communication interface between the data storage system 2000 and the external host. In some example embodiments, the data storage system 2000 may communicate with the external host according to any one of interfaces such as a universal serial bus (USB), a peripheral component interconnect express (PCI-Express), serial advanced technology attachment (SATA), an M-Phy for universal flash storage (UFS), etc. In some example embodiments, the data storage system 2000 may operate by power supplied from the external host through the connector 2006. The data storage system 2000 may further include a power management integrated circuit (PMIC) for distributing power supplied from the external host to the controller 2002 and the semiconductor package 2003.

The controller 2002 may write data to or read data from the semiconductor package 2003, and may improve an operating speed of the data storage system 2000.

The DRAM 2004 may be a buffer memory for mitigating a speed difference between the semiconductor package 2003 as a data storage space and the external host. The DRAM 2004 included in the data storage system 2000 may operate as a kind of cache memory, and may provide a space for temporarily storing data in a control operation on the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, semiconductor chips 2200 on the package substrate 2100, adhesive layers 2300 on lower surfaces of the semiconductor chips 2200, respectively, a connection structure 2400 electrically connecting the semiconductor chips 2200 to the package substrate 2100, and a molding layer 2500 covering the semiconductor chips 2200 and the connection structure 2400 on the package substrate 2100.

The package substrate 2100 may be a printed circuit board including package upper pads 2130. Each semiconductor chip 2200 may include an I/O pad 2210. The I/O pad 2210 may correspond to the I/O pad 1101 of FIG. 20. Each of the semiconductor chips 2200 may include gate stack structures 3210 and channel structures 3220. Each of the semiconductor chips 2200 may include the semiconductor device described above with reference to FIGS. 1 to 15.

In some example embodiments, the connection structure 2400 may be a bonding wire electrically connecting the I/O pad 2210 to the package upper pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. According to embodiments, in each of the first and second semiconductor packages 2003a and 2003b, the semiconductor chips 2200 may be electrically connected to each other by a connection structure including a through-electrode (through silicon via (TSV)) instead of the bonding wire-type connection structure 2400.

In some example embodiments, the controller 2002 and the semiconductor chips 2200 may be included in one package. In an example embodiment, the controller 2002 and the semiconductor chips 2200 may be mounted on a separate interposer substrate different from the main board 2001, and the controller 2002 and the semiconductor chips may be connected to each other by a wiring formed on the interposer substrate.

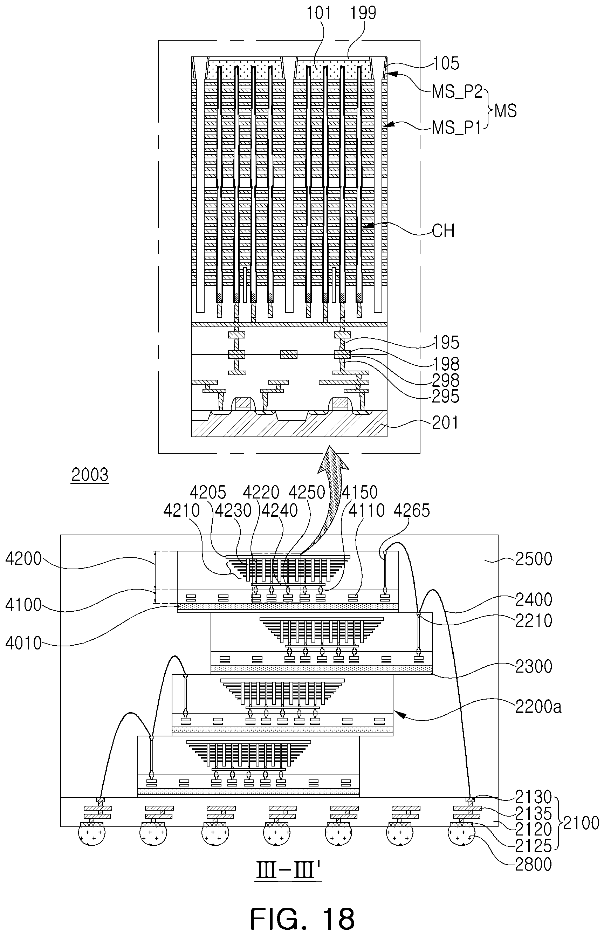

FIG. 18 is a cross-sectional view schematically illustrating a semiconductor package according to some example embodiments. FIG. 18 illustrates an example embodiment of the semiconductor package 2003 of FIG. 17, and conceptually illustrates a region taken along line III-III' of the semiconductor package 2003 of FIG. 17.

Referring to FIG. 18, in the semiconductor package 2003, the package substrate 2100 may be a printed circuit board (PCB. The package substrate 2100 may include a package substrate body portion 2120, the package upper pads 2130 (refer to FIG. 17) on an upper surface of the package substrate body portion 2120, package lower pads 2125 on a lower surface of the package substrate body portion 2120 or exposed through the lower surface of the package substrate body portion 2120, and internal wirings 2135 electrically connecting the package upper pads 2130 to the package lower pads 2125 within the package substrate body portion 2120. The package upper pads 2130 may be electrically connected to the connection structures 2400. The package lower pads 2125 may be connected to the wiring patterns 2005 of the main board 2001 of the data storage system 2000 as illustrated in FIG. 17 through conductive connection portions 2800.

In the semiconductor package 2003, each of the semiconductor chips 2200a may include a semiconductor substrate 4010, a first structure 4100 on the semiconductor substrate 4010, and a second structure 4200 bonded to the first structure 4100 on the first structure 4100 in a wafer bonding method.

The first structure 4100 may include a peripheral circuit region including a peripheral wiring 4110 and first bonding structures 4150. The second structure 4200 may include a common source line 4205, a gate stack structure 4210 between the common source line 4205 and the first structure 4100, and channel structures 4220 passing through gate stack structure 4210 and a separation region 4230, and second bonding structures 4250 electrically connected to the word lines (WL of FIG. 16) of the gate stack structure 4210 and the memory channel structures 4220, respectively. For example, the second bonding structures 4250 may be electrically connected to the memory channel structures 4220 and the word lines (WL of FIG. 20) through bit lines 4240 electrically connected to the memory channel structures 4220 and gate contacts (160 of FIG. 2B) electrically connected to word lines (WL of FIG. 16), respectively. The first bonding structures 4150 of the first structure 4100 and the second bonding structures 4250 of the second structure 4200 may be bonded while being in contact with each other. Bonded portions of the first bonding structures 4150 and the second bonding structures 4250 may be formed of, for example, copper (Cu).

As illustrated in the enlarged view, the second structure 4200 may include the separation structures MS having the first and second portions MS_P1 and MS_P2. In each of the semiconductor chips 2200a, each of the separation structures MS may have a bent portion defined by the first and second portions MS_P1 and MS_P2, as described above with reference to FIGS. 1 to 15.

The semiconductor chips 2200a of FIG. 18 may be electrically connected to each other by connection structures 2400 in the form of bonding wires. However, in some example embodiments, semiconductor chips in one semiconductor package, such as the semiconductor chips 2200a, may be electrically connected to each other by a connection structure including a through-electrode TSV.

In the structure in which two or more semiconductor structures are bonded, the gate electrode layers may be formed after the bonding process is performed for bonding, thereby improving the process difficulty, so that a semiconductor device having improved productivity and a data storage system including the same may be provided.

While some example embodiments have been illustrated and described above, it will be apparent to those skilled in the art that modifications and variations could be made without departing from the scope of the present inventive concept as defined by the appended claims.

## Claims

1. A semiconductor device (100, 100a-g, 1100) comprising:
a first semiconductor structure (S1, 1100F) including a lower substrate (201); and
a second semiconductor structure (S2, 1100S) on and bonded to the first semiconductor structure (S1, 1100F) through a bonding structure (195, 196, 198, 295, 298, 4150, 4250), the second semiconductor structure (S2, 1100S) comprising:
a pattern structure (101);
an upper insulating layer (199, 199') on the pattern structure (101);
a stack structure (GS, 3210, 4210) including gate electrode layers (130) and interlayer insulating layers (120, 120a, 120b) alternately stacked between the first semiconductor structure (S1, 1100F) and the pattern structure (101) in a vertical direction that is perpendicular to a lower surface of the pattern structure (101);
channel structures (CH, 3220, 4220) that extend through the stack structure (GS, 3210, 4210), each channel structure (CH, 3220, 4220) respectively including a channel layer (140); and
separation structures (MS, MS', MS", MS‴) that extend through the stack structure (GS, 3210, 4210) and separate the stack structure (GS, 3210, 4210);
wherein each of the separation structures (MS, MS', MS", MS‴) includes a first portion (MS_P1) that extends through the stack structure (GS, 3210, 4210) and a second portion (MS_P2) that vertically extends from the first portion (MS_P1) and extends through the pattern structure (101), and
wherein the second semiconductor structure (S2, 1100S) further includes a spacer layer (105, 105a) that separates the second portions (MS_P2) of the separation structures (MS, MS', MS", MS‴) from the pattern structure (101).

2. The semiconductor device (100, 100a-g, 1100) of claim 1, wherein the separation structures (MS, MS', MS", MS‴) extend in a first horizontal direction and separate the stack structure (GS, 3210, 4210) into a plurality of stack portions spaced apart from each other in a second horizontal direction that crosses the first horizontal direction.

3. The semiconductor device (100, 100a-g, 1100) of claim 1 or 2, wherein the spacer layer (105, 105a) surrounds an outer surface of the second portion (MS_P2) of each of the separation structures (MS, MS', MS", MS‴).

4. The semiconductor device (100, 100a, 100c-100f, 1100) of any one of claims 1 to 3, wherein an upper end of the spacer layer (105, 105a) is located farther from a surface of the lower substrate (201) than an upper surface of the pattern structure (101) is from the surface of the lower substrate (201).

5. The semiconductor device (100, 100a, 1100) of any one of claims 1 to 4, wherein:
each of the separation structures (MS') extends in a first horizontal direction, and
the spacer layer (105a) includes a portion having a width in a second horizontal direction that decreases as a distance from the lower substrate (201) decreases.

6. The semiconductor device (100, 100a-g, 1100) of any one of claims 1 to 5, wherein each of the separation structures (MS, MS', MS", MS‴) has a bent portion (MS_BP) between the first portion (MS_P1) and the second portion (MS_P2).

7. The semiconductor device (100, 100a-g, 1100) of claim 6, wherein the bent portion (MS_BP) is located on a level closer to a surface of the lower substrate (201) than a level of a lower surface of the pattern structure (101) is to the surface of the lower substrate (201).

8. The semiconductor device (100d) of any one of claims 1 to 7, wherein:
the first portion (MS_P1) of each separation structure (MS) has a continuous shape and extends in a first horizontal direction, and
the second portion (MS_P2) of each separation structure (MS) has an intermittent shape and extends in the first horizontal direction on the first portion.

9. The semiconductor device (100e) of any one of claims 1 to 7, wherein:
each of the separation structures (MS) includes an insulating material that extends continuously within the first portion (MS_P1) and the second portion (MS_P2), and
the insulating material includes at least one of silicon oxide, silicon nitride, or silicon carbide.

10. The semiconductor device (100c) of any one of claims 1 to 9, further comprising:
a plate conductive layer (102) between the upper insulating layer (199') and the pattern structure (101),
wherein at least one of the separation structures (MS‴) includes a vertical conductive layer that is integrated with the plate conductive layer (102), wherein the vertical conductive layer including the same metal material as a material of the plate conductive layer (102), and wherein the at least one separation structure (MS‴) includes an insulating liner that surrounds an outer surface of the vertical conductive layer.

11. The semiconductor device (100c) of any one of claims 1 to 10, wherein:
each of the separation structures (MS) extends in a first horizontal direction,
the first portion (MS_P1) of each of the separation structures (MS) has a width in a second horizontal direction, perpendicular to the first horizontal direction, that decreases in a direction from the first semiconductor structure (S1, 1100F) toward the pattern structure (101), and
the second portion (MS_P2) of each of the separation structures (MS) has a width in the second horizontal direction, that increases in a direction from the first semiconductor structure (S1, 1100F) toward the pattern structure (101).

12. The semiconductor device (100, 100a-g, 1100) of any one of claims 1 to 11, further comprising:
a conductive pad (106) on the upper insulating layer (199, 199');
a landing pad (108) that extends through the upper insulating layer (199, 199') and the pattern structure (101) and is in contact with the conductive pad (106);
a pad spacer (107) that surrounds an outer surface of the landing pad (108); and
an input/output (I/O) contact that electrically connects an upper wiring structure (160, 165, 167, 170, 180) to the landing pad (108),
wherein the landing pad (108) is spaced apart from the pattern structure (101) by the pad spacer (107).

13. The semiconductor device (100, 100a-g, 1100) of claim 12, wherein an upper surface of the landing pad (108) is coplanar with or higher than an upper surface of the second portion (MS_P1).

14. The semiconductor device (100, 100a-g, 1100) of any one of claims 1 to 13, wherein:
the gate electrode layers (130) extend to have different lengths in a horizontal direction, each gate electrode layer (130) including a gate pad region (118P, 130P) having a lower surface that is exposed downwardly,
wherein the semiconductor device (100, 100a-g, 1100) further includes:
an upper wiring structure (160, 165, 167, 170, 180);
gate contacts (160) connected to the upper wiring structure (160, 165, 167, 170, 180) and extending into the pattern structure (101) through the gate pad regions (130P) of the gate electrode layers (130); and
an insulating structure (125) alternately arranged with the interlayer insulating layers (120, 120a, 120b) on the gate pad regions (130P) and surrounding the gate contacts (160), respectively.

15. The semiconductor device (100, 100a-g, 1100) of claim 14, wherein a lower surface of each of the gate contacts (160) is coplanar with a lower surface of each of the channel structures (CH, 3220, 4220).
